# EUROPEAN PATENT APPLICATION

(11) **EP 0 875 925 A2**
(43) Date of publication of application: **04.11.1998**
(21) Application number: 98303409.1
(22) Date of filing: 30.04.1998
(51) Int. Cl.: H01L 21/3205

(54) **Method of manufacturing capacitors in integrated circuits**

(30) Priority: 30.04.1997 KR 9716853; 25.06.1997 KR 9727270
(71) Applicant: Samsung Electronics Co., Ltd., Suwon-city, Kyungki-do (KR)
(72) Inventor: Oh, Chang-Bong, Yongin-shi, Kyungki-do (KR); Kim, Young-Wug, Suwon, Kyungki-do (KR)
(74) Representative: Tunstall, Christopher Stephen

(57) **Abstract**

A method of manufacturing a capacitor whose top and bottom electrodes have a similar doping concentration to each other. In the method, a top surface of the capacitor top electrode is exposed and is then doped using the same doping process as the capacitor bottom electrode. Other elements can be prevented from becoming influenced by dopants during the doping.

## Description

The present invention relates to a method for manufacturing a semiconductor device and, particularly, to a method for manufacturing a capacitor suitable for use in an integrated circuit in which analogue and digital functions are embodied on a single chip.

### Background of Invention

Recent increases in integration and performance of semiconductor devices have led to the development of custom integrated circuits with several functions, such as both analogue and digital functions. Combined analogue and digital functions are required, for example, in multi-media, communication, or graphic processing units. To meet this need, improved integrated circuit capacitors and resistors are required.

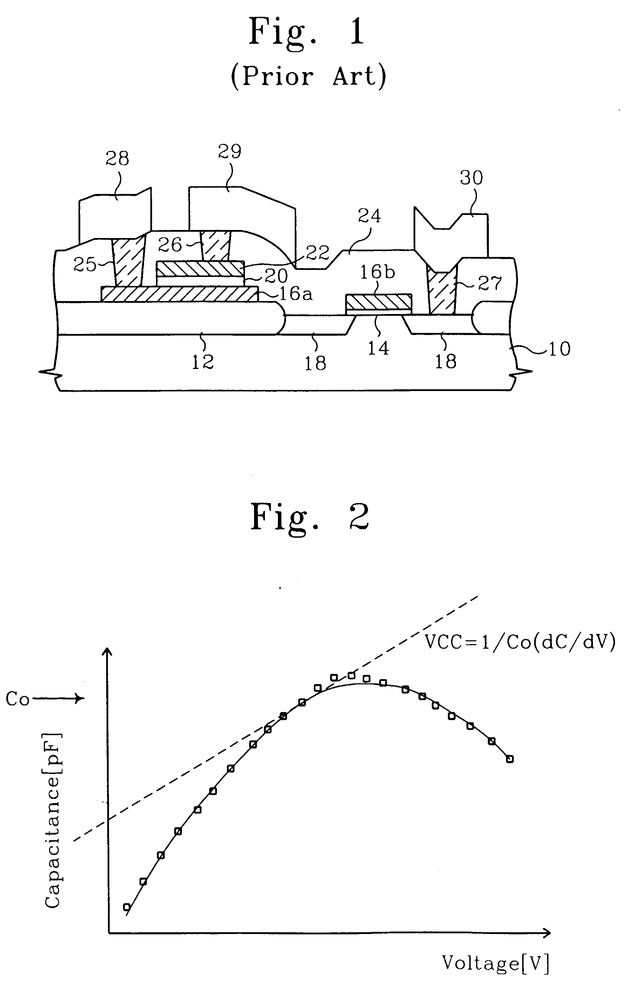

Fig. 1 illustrates a known capacitor used for analogue integrated circuitry. Thin films of polysilicon or metal are used as capacitor electrodes 16a, 22 and a silicon oxide (SiO₂) or silicon nitride (Si₃N₄) film is used as a dielectric layer 20. In this figure, there are two defined regions on a semiconductor substrate 10: an active region and a passive region. The capacitor is formed in the passive region, more particularly, on a field oxide layer 12. The capacitor is provided with bottom electrode 16a and top electrode 22 with capacitor dielectric layer 20 interposed between them.

A transistor is formed in the active region. The transistor is provided with a gate electrode 16b on a gate oxide layer 14 on the active region of the substrate 10. The transistor is also provided with source/drain regions 18 in the semiconductor substrate 10 adjacent to the gate electrode 16b. An interlayer insulating layer 24 is deposited over the upper surface of the structure, comprising upper portions of substrate, top electrode 22 and gate electrode 16b. Contact plugs 25, 26 and 27 are formed traversing the interlayer insulating layer 24, to respectively electrically connect bottom electrode 16a, top electrode 22 and gate electrode 16b with interconnection wirings 28, 29 and 30.

If the contact plugs are formed using a tungsten (W) plug process, the interconnection wirings are typically made of a different material, such as aluminium, copper, or an alloy containing materials such as silicon, titanium. If the contact plugs are formed using an aluminium (Al) sputtering or an aluminium-flow process, the interconnection wirings are typically made of the same material as the contact plugs.

In fabrication of the above-mentioned capacitor, a doped polysilicon layer is typically used as the capacitor bottom electrode 16a and an ONO (oxide-nitride-oxide) layer having a thickness of several tens of nanometres (several hundred angstroms) as the capacitor dielectric layer 20. In particular, the capacitor top electrode 22 may be formed of the same material as the transistor's gate electrode 16b. The top electrode 22 and the gate electrode 16b are typically simultaneously formed by depositing and patterning a polysilicon layer.

So as to reduce a resistance value of the bottom electrode 16a, after deposition of the polysilicon layer, buffer oxidation and dopant impurity implantation, a thermal treatment, or 'anneal' process must be performed for driving in and/or activating the dopant implanted impurity species.

On the other hand, in order to improve a signal to noise ratio (SNR) in CMOS logic and analogue devices, such as analogue to digital converters and the like, it is very important to decrease the voltage coefficient of capacitance (VCC) of the analogue capacitor. A decrease in VCC means that the change in capacitance value with voltage applied to the analogue capacitor is low.

The present invention aims to decrease the voltage coefficient of capacitance in an integrated circuit analogue capacitor.

If the doping concentration of a portion of the capacitor top electrode close or adjacent to the interface with the dielectric layer is identical to that of a similar portion of the capacitor bottom electrode, the resultant capacitor may have a far smaller VCC characteristic.

Such a capacitor may further have a symmetrical characteristic with respect to zero voltage in a CV(capacitance-voltage) curve, as shown in Fig. 2. The VCC can be given by the following equation:$\text{VCC =} \frac{\text{1}}{\text{Co}} \text{·} \frac{\text{dC}}{\text{dV}}$ where Co is a nominal capacitance and dC/dV is variation of a capacitance with an applied voltage.

However, referring again to Fig. 1, in a typical manufacturing process, since the top and gate electrodes 22 and 16b are simultaneously formed, the gate electrode 16b is doped by a POCl₃ n-type diffusion doping and drive-in process. The bottom electrode 16a is doped by an implantation of dopant impurity. The doping level of the bottom electrode 16a is far lower than that of the gate electrode 22 and top electrode 16b.

Significant decrease in the VCC of such a capacitor is difficult to achieve. Such a capacitor also has an asymmetrical C-V curve.

In addition, high value resistors with sheet resistance of several hundred ohm/square to several kohm/square must be designed on the chip in which the capacitor is embodied. If, as is typical, the resistors are simultaneously formed with the bottom electrode 16a, the doping concentration of the bottom electrode 16a must be further lowered as compared to that of the top electrode 22. This causes serious problems in that the VCC value and asymmetry of the C-V curve characteristic are further increased.

### Summary of the Invention

The present invention aims to provide a method of manufacturing a capacitor with a reduced voltage coefficient of capacitance (VCC).

The invention further aims to provide a method for manufacturing a capacitor having improved symmetry in its capacitance-voltage characteristic curve.

The invention also aims to provide a method for manufacturing improved capacitors and resistors in integrated circuits.

Accordingly, the present invention provides a method of manufacturing a capacitor, comprising the steps of: (a) defining active and passive regions on a substrate; (b) forming a capacitor bottom electrode; (c) forming a capacitor dielectric on the bottom electrode; (d) forming a capacitor top electrode on the capacitor dielectric; (e) forming an interlayer insulating layer; (f) planarising and removing the interlayer insulating layer from its top surface until a top surface of the capacitor top electrode is exposed; and (g) doping the capacitor top electrode through its exposed top surface.

The step (b) may comprise the steps of: (b1) forming a first polysilicon layer on the substrate; (b2) doping the first polysilicon layer using a doping process; and (b3) patterning the first polysilicon layer.

The step (b) may further comprise forming a thermal oxide layer on the first polysilicon layer.

The step (d) may comprise the steps of forming a second polysilicon layer; and patterning the second polysilicon layer.

The step (g) may comprise doping the capacitor top electrode, using the same doping process as used for doping the first polysilicon layer.

The step (c) may comprise the steps of forming a dielectric layer; and patterning the dielectric layer.

The present invention also provides a method for manufacturing a capacitor, comprising the steps of: (a) defining active and passive regions on a substrate; (b) forming a capacitor bottom electrode, by: forming a first polysilicon layer on the substrate; doping the first polysilicon layer; and forming a thermal oxide layer (210) on the first polysilicon layer; (c) forming a capacitor dielectric on the bottom electrode; and (d) forming a capacitor top electrode on the capacitor dielectric.

Preferably, during forming of the thermal oxide layer, dopant impurity ions in the first polysilicon layer are segregated toward a top surface portion thereof, to increase a doping concentration of the top surface portion of the first polysilicon layer.

In such a method, the step (c) may include forming a dielectric layer on the thermal oxide layer; and patterning the dielectric layer and the thermal oxide layer to form the capacitor dielectric layer on the capacitor bottom electrode.

In such a method, the step (b) may further include the step of patterning the first polysilicon layer to form a capacitor bottom electrode on the passive region.

In such a method, the step (d) may comprise the steps of forming a second polysilicon layer on the substrate including the capacitor dielectric layer; doping the second polysilicon layer; and patterning the second polysilicon layer to form the capacitor top electrode.

In such a method, the second polysilicon layer, is preferably doped, using the same doping process as used for doping the first polysilicon layer.

The method may further comprise the steps of: (e) forming an interlayer insulating layer on the substrate including the capacitor top electrode; (f) planarising and removing the interlayer insulating layer until a top surface of the capacitor top electrode is exposed; and (g) doping the capacitor top electrode through its exposed top portion.

In the method according to the present invention, the capacitor top electrode is preferably doped through its top portion. It is preferably also doped using the same doping process as the doping process used for doping the first polysilicon layer.

The step of doping the first polysilicon layer may be performed by an implantation, or by POCl₃ diffusion.

In any method according to the present invention, the step of planarising and removing the interlayer insulating layer may be performed by a CMP (chemical mechanical polishing) process, or by deposition and etch back of a sacrificial layer.

In any method according to the present invention, the method may further comprise the steps of: forming a gate oxide layer on the active region; and forming a gate electrode on the gate oxide layer.

The gate oxide layer may be formed beneath a first polysilicon layer, in which case, the method may comprise the step of patterning the first polysilicon layer to form the capacitor bottom electrode on the passive region and the gate electrode on the gate oxide layer.

The gate oxide layer may be formed beneath a second polysilicon layer, in which case the method may comprise the step of patterning the second polysilicon layer to form the capacitor top electrode on the field oxide layer and the gate electrode on the gate oxide layer.

In any method according to the present invention, step (a) may comprise forming a field oxide layer on a semiconductor substrate.

The dielectric layer may be made of at least one of silicon oxide, silicon nitride and ONO.

### Brief Description of the Drawings

This invention is described below, with respect to certain embodiments, given by way of examples only, with reference to the accompanying drawings in which:
Fig. 1 is a cross-sectional view of a conventional integrated circuit capacitor;
Fig. 2 is a capacitance-voltage curve showing characteristics of a double polysilicon electrode integrated circuit capacitor having a good VCC (voltage-coefficient of capacitance) value;
Figs. 3A to 3F illustrate an integrated circuit capacitor according to at various stages in a manufacturing process according to a first embodiment of the present invention; and
Figs. 4A to 4E illustrate an integrated circuit capacitor according to at various stages in a manufacturing process according to a second embodiment of the present invention.

### Detailed Description of the Drawings

### First Embodiment

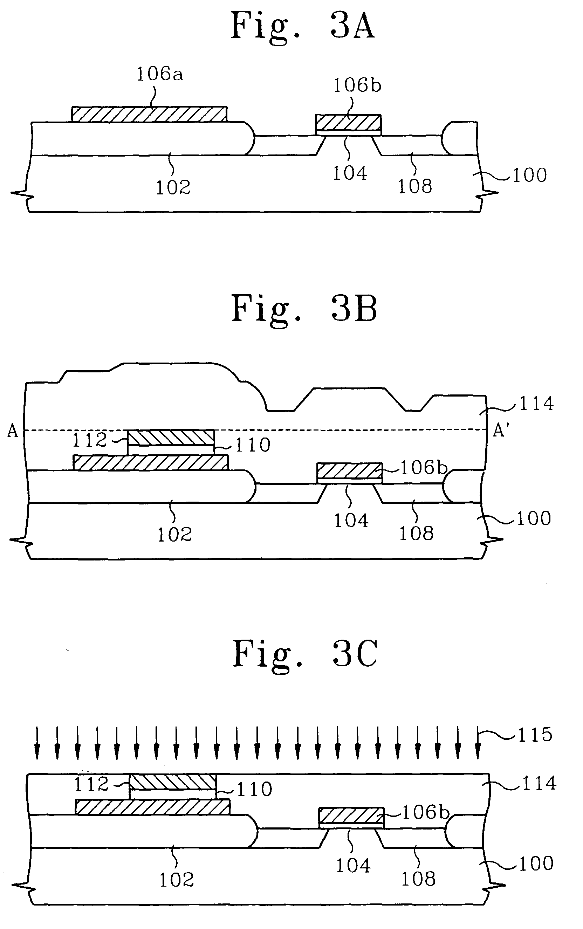

As shown in Fig. 3A, a field oxide layer 102 having a thickness of about 12nm is formed on a surface of a silicon substrate 100 to define active and passive regions thereon. Then a gate oxide layer 104 is formed on the active region. Next, a first polysilicon layer having a thickness of about 200nm is deposited over the silicon substrate 100 including the field oxide layer 102 and the gate oxide layer 104. The first polysilicon layer is then doped with an impurity, for example, arsenic ions implanted with an energy of about 70keV.

The doping of the first polysilicon layer may be accomplished either by implanting dopant impurity and driving in using thermal anneal treatment, or by diffusing in a dopant impurity, such as by means of POCl₃ deposition and anneal. Although not shown in Fig. 3A, the doping of the first polysilicon layer is typically carried out after forming a buffer oxide on the polysilicon layer by heating to a temperature of 850°C to 950°C in an oxidising ambient.

Subsequently, an etching process of the doped polysilicon layer is carried out to pattern the first polysilicon layer so as to simultaneously form a gate electrode 106b on the gate oxide layer 104 and a capacitor bottom electrode 106a on the field oxide layer 102.

Alternatively, if the gate electrode and the capacitor bottom electrode are not simultaneously formed, additional process steps for forming the capacitor bottom electrode are required. For example, a further polysilicon layer may be deposited and patterned to form the capacitor bottom electrode, after formation of the gate electrode 106b.

After formation of the gate electrode 106b, source/drain regions 108 are formed at either side of the gate electrode 106b, in the silicon substrate 100.

With reference to Fig. 3B, a capacitor dielectric layer and a second polysilicon layer are sequentially deposited on the structure of figure 3A, and are selectively etched to form a capacitor dielectric layer 110 and a capacitor top electrode 112, stacked on the capacitor bottom electrode 106a. The capacitor dielectric layer 110 may be made of silicon oxide, silicon nitride, ONO, or a combination of some or all of these, or any suitable dielectric material. Next, an interlayer insulating layer 114 is deposited on the resulting structure. This interlayer insulating layer 114 may be made of BPSG, PEOX, TEOS or the like, or any suitable insulating material.

Referring to Fig. 3C, a CMP (chemical mechanical polishing) process is carried out until a top surface (indicated by a dotted line of A-A' in Fig. 3B) of the capacitor top electrode 112 is completely exposed, so that the structure has a wholly planarised upper surface.

Alternatively, deposition and etchback of a sacrificial layer may be used to achieve a similar effect, but care must be taken to fully expose the upper surface of top electrode 112 without excessively thinning the interlayer dielectric layer 114.

The top electrode 112 is then doped by a doping process, such as an impurity implantation or a POCl₃ deposition, and anneal.

It is preferable that the top electrode 112 is doped with an impurity by the same doping process as the bottom electrode 106a, so as to achieve similar doping densities in the two electrodes. Other elements, for example, the gate electrode 106b and the bottom electrode 106a are not influenced during the doping of the top electrode 112. This is achieved because the interlayer insulating layer 114 has a thickness sufficient to prevent dopants from reaching other elements during the doping process.

For example resistors, which may be formed of either first or second polysilicon layers, are not affected by the doping of the capacitor top electrode.

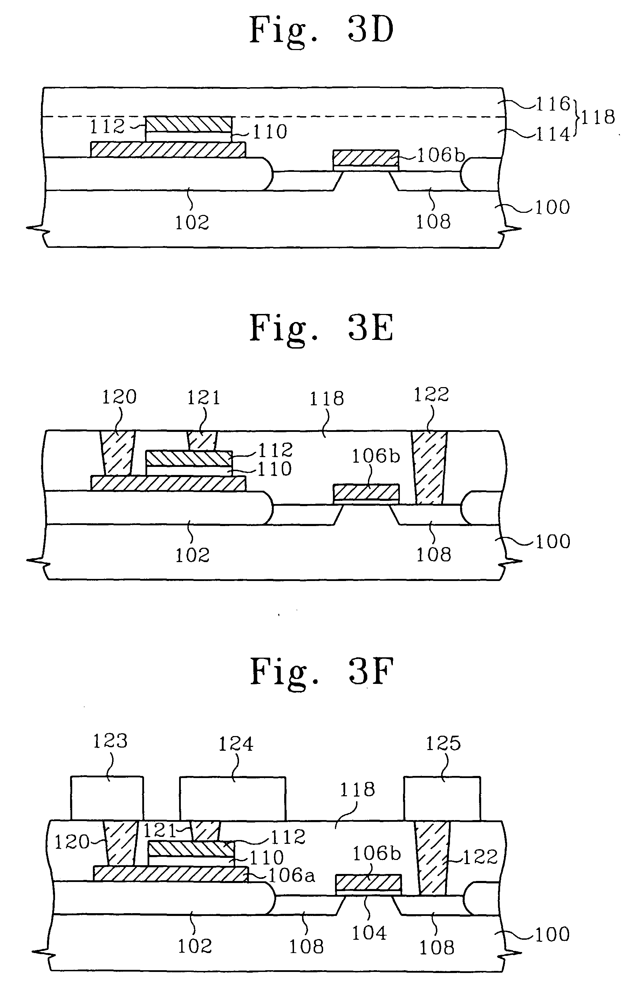

In Fig. 3D, an additional interlayer insulating layer 116 is deposited over the interlayer insulating layer 114 and the top electrode 112. This serves as an interlayer insulating layer for the top electrode 112 with respect to a later formed wiring layer. Reference numeral 118 indicates a combined interlayer insulating layer which consists of the two layers 114 and 116.

As shown in Figs. 3E and 3F, contact holes are formed to the bottom electrode 106a, the top electrode 112 and source/drain region 108. A conductive material is filled into the contact holes to form respective contact plugs 120, 121 and 122. The contact plugs are provided to enable electrical connection with respective, later-formed interconnect wirings 123, 124 and 125. The formation of the contact plugs may be accomplished by a tungsten (W) plug process, an aluminium sputtering process or an aluminium flow process. The contact plugs may be made from one or more of tungsten (W), aluminium (A1), copper (Cu) and the like, or any other suitable conductive material.

Finally, a metallisation process is carried out to form the interconnection wirings 123-125 as shown in Fig. 3F. This may be carried out by deposition and patterning of a metal layer, or a damascene process, or any other suitable method. The wirings may be of aluminium, copper, alloys of these, or any other suitable conductive material. As a result, a capacitor and its connections are completely manufactured.

According to an aspect of the present invention, since dopant impurities are doped in to the capacitor top electrode 112 and do not penetrate into the other elements during such doping, the doping level of the top electrode 112 may be freely chosen, for example, made approximately equal to that of the capacitor bottom electrode 106a. By suitable choice of doping of the top electrode, the capacitor may have increased symmetry in its C-V curve a decreased voltage-coefficient of capacitance.

Since the capacitor top and bottom electrodes 112 and 106a are preferably doped by the same doping process, the respective doping levels may be made nearly equal to each other.

Although, in this embodiment, it has been described that a capacitor bottom electrode 106a and a gate electrode 106b of MOS transistor are simultaneously formed, the present invention is similarly applicable to the simultaneous formation of the gate electrode 106b and a capacitor top electrode 112. In this case, after forming a capacitor bottom electrode 106a and capacitor dielectric layer 110, gate oxide 104 is formed on the active region, and then capacitor top electrode 122 and the gate electrode 106b are simultaneously formed from the second polysilicon layer. Next, source/drain regions 108 are formed. The gate electrode 106b formed in this way does not receive the doping introduced into the capacitor top electrode, and remains in the state in which it was deposited. A capacitor manufactured thus has similar advantages in respect of VCC value and symmetry of its C-V curve as compared with a capacitor manufactured according to the previously described method.

### Second Embodiment

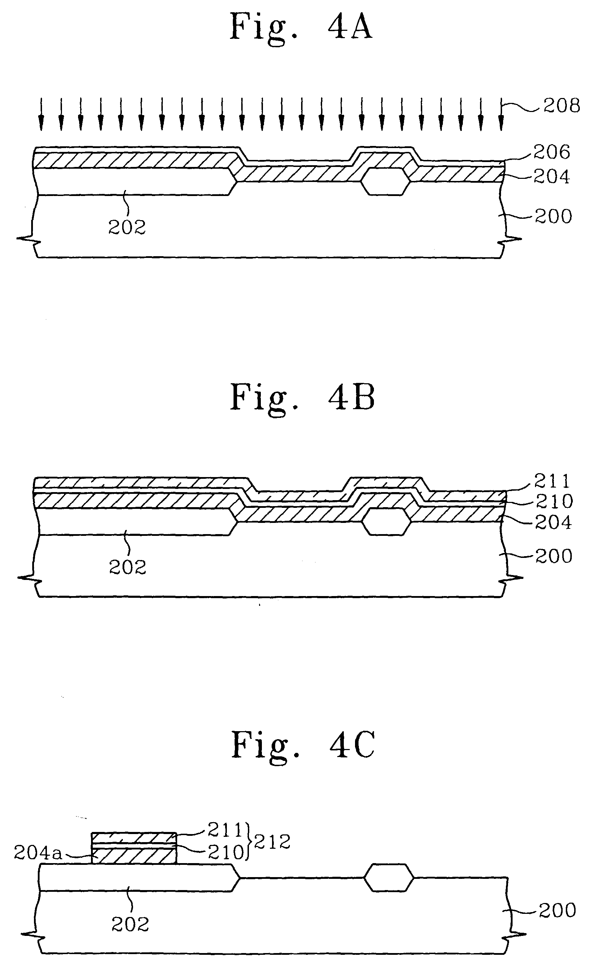

Figs. 4A to 4E show a second embodiment of the present invention. Referring to Fig. 4A, a field oxide layer 202 having a thickness of about 12nm is formed on a surface of a silicon substrate 200 to define active and passive regions thereon. Then an implantation of a dopant impurity is carried out, for controlling threshold voltages of later formed MOS transistors. A first polysilicon layer 204 and a buffer oxide layer 206 are sequentially formed over the substrate 200 and the field oxide layer 202. The polysilicon layer 204 has a thickness of about 200nm. The buffer oxide layer 206 is formed by heating in an oxidising atmosphere to a temperature of 850°C to 950°C.

An implantation is then carried out to inject dopant impurities 208 into the polysilicon layer 204. As the dopant impurities 208, arsenic or phosphorus may be used, at an implant energy of about 70keV.

As shown in Fig. 4B, after removal of the buffer oxide layer 206, a thermal oxide layer 210 and a dielectric layer 211 are sequentially formed on the doped first polysilicon layer 204. The thermal oxide layer 210 is formed by heating in an oxidising ambient to a temperature of 850°C to 950°C. The dielectric layer 211 has a thickness from 5nm to 100nm.

During formation of the thermal oxide layer 210, the implanted impurity ions 208 in the doped first polysilicon layer 204 become concentrated toward a top surface portion of the doped first polysilicon layer 204. As a result, a doping concentration at the top surface of the doped first polysilicon layer 204 becomes higher than that at other portions thereof.

The dielectric layer 211 may be made of at least one of silicon oxide, silicon nitride and ONO, or any other suitable insulating material.

The dielectric layer 211 and the thermal oxide layer 210 will serve as the dielectric layer of the capacitor, when completed. Their characteristics and thicknesses therefore determine the capacitance of the capacitor, as they together serve as capacitor dielectric layer 212.

With reference to Fig. 4C, an etching or similar process is carried out to sequentially selectively remove the dielectric layer 211, the thermal oxide layer 210 and the doped first polysilicon layer 204, so that a capacitor bottom electrode 204a and a capacitor dielectric layer 212 remain, formed on the field oxide layer 202.

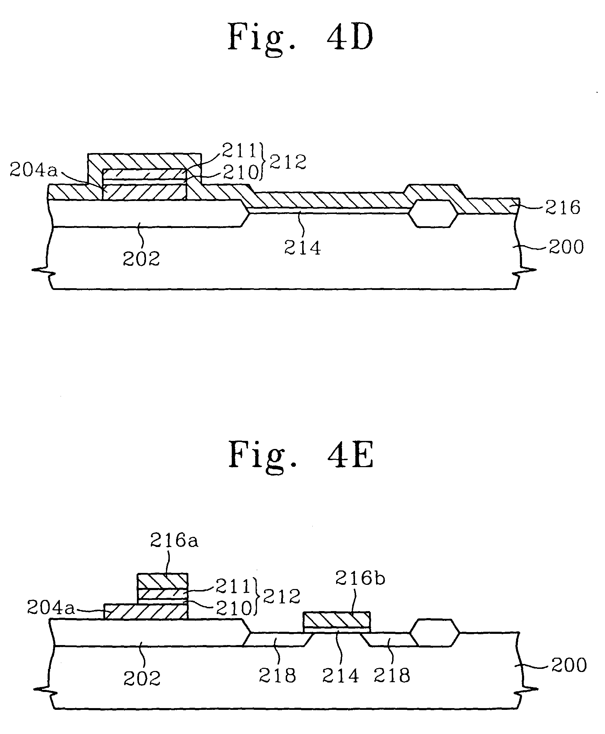

In Fig. 4D, a gate oxide layer 214 for a MOS transistor is formed on the active region. A second polysilicon layer 216 is then deposited over the structure.

The second polysilicon layer may now be partially or fully doped. Any such doping will affect all parts of the second polysilicon layer. This may be accomplished either by implanting an impurity followed by a driving-in of the implanted impurity by thermal anneal treatment, or by diffusing in an impurity, such as by means of POCl₃ deposition and anneal. The doping process used should be the same doping process as used in doping the capacitor bottom electrode 204a.

As shown in Fig. 4E, an etching or similar process is carried out on the second polysilicon layer 216 to simultaneously form a gate electrode 216b on the gate oxide layer 214 and a capacitor top electrode 216a on the capacitor dielectric layer 212. Finally, a source/drain region 218 is formed at both sides of the gate electrode 216b in the substrate 200.

Although not shown, an interlayer insulating layer is deposited over the structure. Similarly to the first embodiment, the interlayer insulating layer may be made of BPSG, PEOX, TEOS or the like, or any suitable insulating material. Next, a CMP process is carried out until the top surface of the capacitor top electrode 216a is completely exposed, and the structure has a wholly planarised upper surface.

Alternatively, deposition and etchback of a sacrificial layer may be used to achieve a similar effect, but care must be taken to fully expose the upper surface of top electrode 216a without excessively thinning the interlayer dielectric layer.

If the second polysilicon layer is not already sufficiently doped in earlier steps of the process, the exposed polysilicon of the capacitor top electrode 216a is now doped. This may be accomplished either by implanting an impurity followed by a driving-in of the implanted impurity by thermal anneal treatment, or by diffusing in an impurity, such as by means of POCl₃ deposition and anneal. The doping process used should be the same doping process as used in doping the capacitor bottom electrode 204a. Other elements, for example, the gate electrode 216b and the bottom electrode 204a do not become influenced during this doping of the top electrode 216a, because the interlayer insulating layer is thick enough to prevent dopants from reaching the other elements during the doping process.

Subsequently, although not shown, contact holes are formed on the capacitor electrodes 204a and 216a and the source/drain region 218, respectively, and then a conductive material is filled into the contact holes to form contact plugs, or contact electrodes. After forming the contact plugs, a metallisation is carried out to form interconnect wirings (not shown). The plugs and/or the wirings may be formed from one or more of tungsten, aluminium, copper, titanium, silicon, alloys of some of these, or any other suitable conductive material.

In the capacitor manufactured according to this embodiment, the capacitor bottom electrode 204a has a doping concentration higher at its top surface portion than at other portions. The first polysilicon layer 204 includes a highly doped upper surface, constituting the capacitor bottom electrode 204a. In addition, its mean doping level remains low, so it may be used as a resistor. That is, the first polysilicon layer 204 can be used both as the capacitor bottom electrode 204a and as a resistor. Therefore, additional process steps otherwise required for forming the resistor can be omitted.

Also, since dopants are selectively doped into the capacitor top electrode 216a and not into the other elements during the final doping step, the doping level of the top electrode 216a may be freely chosen. In particular, the doping level may be made nearly equal to that of the capacitor bottom electrode 204a, and in particular to the highly doped upper surface of the capacitor bottom electrode. Because the doping levels of the capacitor top and bottom electrodes are nearly equal to each other, the capacitor may have improved symmetry in its C-V curve, and a decreased voltage-coefficient of capacitance.

As the doping applied to the capacitor top electrode is only applied to the top electrode, and not any other elements, which are covered by the interlayer dielectric, resistors may also advantageously be made from the second polysilicon layer. The second polysilicon layer may be initially deposited with a low doping level, providing a high resistivity layer for producing resistors. By selectively further doping the capacitor top electrodes, and not further doping the resistors, the resistors may be produced of polysilicon having a higher resistivity than either the top or bottom capacitor electrode. More importantly, the resistivity of the polysilicon of the resistors may be independent of the resistivity of both of the capacitor electrodes.

Although the invention has been described with a silicon wafer as the substrate, the present invention is, of course, similarly applicable to an SOS (silicon-on-sapphire) substrate in which silicon exists in only a surface region thereof or even generally to an SOI (silicon-on-insulator) or other substrate.

## Claims

1. A method for manufacturing a capacitor, comprising the steps of:
a) defining active and passive regions on a substrate (100);
b) forming a capacitor bottom electrode (106a);
c) forming a capacitor dielectric (110) on the bottom electrode;
d) forming a capacitor top electrode (112) on the capacitor dielectric,
characterised in that the method further comprises the steps of:
e) forming an interlayer insulating layer (114);
f) planarising and removing the interlayer insulating layer from its top surface until a top surface of the capacitor top electrode is exposed; and
g) doping (115) the capacitor top electrode through its exposed top surface.

2. The method according to claim 1, wherein step (b) comprises the steps of:
b1) forming a first polysilicon layer on the substrate;
b2) doping the first polysilicon layer using a doping process; and
b3) patterning the first polysilicon layer.

3. The method according to claim 2 wherein the step (g) comprises doping the capacitor top electrode using the same doping process as used for doping the first polysilicon layer.

4. The method according to any of claims 1 - 3, wherein the step (d) comprises the steps of:
d1) forming a second polysilicon layer; and
d2) patterning the second polysilicon layer.

5. The method according to any preceding claim, wherein the step (c) comprises the steps of:
c1) forming a dielectric layer; and
c2) patterning the dielectric layer.

6. The method according to any preceding claim, wherein step (f) is performed by a CMP (chemical mechanical polishing) process.

7. The method according to any preceding claim, wherein step (f) is performed by deposition and etch back of a sacrificial layer.

8. The method according to any preceding claim, further comprising the steps of:
forming a gate oxide layer on the active region; and
forming a gate electrode (106b) on the gate oxide layer.

9. The method according to claim 8 wherein the gate oxide layer is formed beneath a first polysilicon layer, further comprising the step of:
(b') patterning the first polysilicon layer to form the capacitor bottom electrode (106a) on the passive region and the gate electrode (106b) on the gate oxide layer.

10. The method according to claim 8 wherein the gate oxide layer is formed beneath a second polysilicon layer, and further comprising the step of:
(d') patterning the second polysilicon layer to form the capacitor top electrode (112) on the field oxide layer and the gate electrode (106b) on the gate oxide layer.

11. The method according to claim 2 wherein the step (b) further comprises forming a thermal oxide layer (210) on the first polysilicon layer.

12. A method of manufacturing a capacitor, comprising the steps of:
a) defining active and passive regions on a substrate (200);
b) forming a capacitor bottom electrode (204a);
c) forming a capacitor dielectric (212) on the bottom electrode;
d) forming a capacitor top electrode (216a) on the capacitor dielectric,
characterised in that the step (b) includes the steps of:
b1) forming a first polysilicon layer (204) on the substrate;
b2) doping (208) the first polysilicon layer;
b3) forming a thermal oxide layer (210) on the first polysilicon layer.

13. The method of claim 12 wherein step (c) includes the steps of:
c1) forming a dielectric layer (211) on the thermal oxide layer;
c2) patterning the dielectric layer and the thermal oxide layer to form the capacitor dielectric layer (212) on the capacitor bottom electrode.

14. The method of claim 12 or claim 13 wherein the step (b) further includes the step of:
b4) patterning the first polysilicon layer to form a capacitor bottom electrode (204a) on the passive region.

15. The method according to one of claims 12 - 14 wherein the step (d) comprises the steps of:
d1) forming a second polysilicon layer on the substrate including the capacitor dielectric layer;
d2) doping the second polysilicon layer (216); and
d3) patterning the second polysilicon layer to form the capacitor top electrode (216a).

16. The method of claim 15 wherein the step (d2) comprises doping the second polysilicon layer, using the same doping process as used in step (b2) for doping the first polysilicon layer.

17. The method according to claim 1 or claim 12, wherein step (a) comprises forming a field oxide layer on a semiconductor substrate.

18. The method according to claim 15, further comprising the steps of:
ca) forming a gate oxide layer (214) on the active region;
d3a) patterning the second polysilicon layer to form a gate electrode (216b) on the gate oxide layer and a capacitor top electrode (216a) on the capacitor dielectric layer.

19. The method according to claim 14, further comprising the steps of:
aa) forming a gate oxide layer (214) on the active region;
b4a) patterning the second polysilicon layer to form a gate electrode (216b) on the gate oxide layer and a capacitor top electrode (216a) on the capacitor dielectric layer.

20. The method according to claim 12, further comprising the steps of:
e) forming an interlayer insulating layer on the substrate including the capacitor top electrode;
f) planarising and removing the interlayer insulating layer until a top surface of the capacitor top electrode is exposed; and
g) doping the capacitor top electrode through its exposed top portion.

21. The method according to claim 20, wherein the capacitor top electrode is doped through its top portion, using the same doping process as the doping process used in step (b2) for doping the first polysilicon layer.

22. The method according to any of claims 12 - 21, wherein said step of doping the first polysilicon layer is performed by an implantation.

23. The method according to any of claims 12 - 21, wherein said step of doping the first polysilicon layer is performed by POCl₃ diffusion.

24. The method according to claim 20, wherein step (f) is performed by a CMP (chemical mechanical polishing) process.

25. The method according to claim 20, wherein step (f) is performed by deposition and etch back of a sacrificial layer.

26. The method according to any of claims 12 - 25, wherein during forming of the thermal oxide layer, dopant impurity in the first polysilicon layer is segregated toward a top surface portion thereof, to increase a doping concentration of the top surface portion of the first polysilicon layer.

27. The method according to claim 5, or claim 13, wherein the dielectric layer is made of at least one selected from a group consisting of oxide, nitride and ONO.

28. The method according to any of claims 1, 12, 18, 19, 20, wherein the steps (a)-(g); (a)-(d); (ca), (d3a); (aa), (b4a); and/or (e)-(g) are performed in the recited order.
